# EUROPEAN PATENT APPLICATION

(11) **EP 2 206 685 A1**
(43) Date of publication of application: **14.07.2010**
(21) Application number: 08842536.8
(22) Date of filing: 15.10.2008
(51) Int. Cl.: C02F 1/461, C01B 31/06, C25B 11/12

(54) **DIAMOND ELECTRODE, TREATMENT DEVICE, AND METHOD FOR PRODUCING DIAMOND ELECTRODE**

(30) Priority: 25.10.2007 JP 2007277714
(71) Applicant: Sumitomo Electric Hardmetal Corp., Itami-shi Hyogo 664-0016 (JP)
(72) Inventor: YOSHIDA, Shigeru, Itami-shi Hyogo 664-0016 (JP); TAKAHASHI, Toshiya, Itami-shi Hyogo 664-0016 (JP); SEKI, Yuichiro, Itami-shi Hyogo 664-0016 (JP); YOSHIDA, Katsuhito, Itami-shi Hyogo 664-0016 (JP); HIGUCHI, Fuminori, Itami-shi Hyogo 664-0016 (JP)
(74) Representative: HOFFMANN EITLE
(86) International application number: PCT/JP2008/068656
(87) International publication number: WO 2009/054295

(57) **Abstract**

The present invention provides a diamond electrode that, in waste water treatment or production of functional water by using electrolysis, does not cause contamination of a solution or release of toxic substances, achieves enhancement of the energy efficiency, has excellent durability, and can endure prolonged use without damage. The present invention further provides a treatment device where the above electrode is used, and a method for manufacturing the above electrode. In a diamond electrode (1a) according to the present invention, the electrode (1a) includes a conductive diamond film (3) covering one surface of a substrate (2). Assuming that the thickness of the substrate (2) is T (µm) and the thickness of the conductive diamond film (3) is t₁ (µm), the ratio between them is 0.0010 ≤ t₁/T ≤ 0.022 and 10 ≤ t₁ ≤ 70.

## Description

### TECHNICAL FIELD

The present invention relates to a diamond electrode, a treatment device and a method for manufacturing the diamond electrode. More particularly, the present invention relates to a diamond electrode that can achieve a long life even if the diamond electrode is used under harsh conditions, and a treatment device where the above electrode is used, and further, a method for manufacturing the above electrode.

### BACKGROUND ART

In recent years, with the rapid development of industry, a large amount of industrial wastewater containing various environmental pollutants has been discharged. In particular, contamination due to factory wastewater containing hazardous chemical substances, organic compounds, heavy metals, hardly degradable substances, and other oxidable species has been becoming more serious.

A method for oxidizing a solute in wastewater by electrolysis is regarded as a convenient method for reducing an amount of undesirable organic compounds and other oxidable species in a prescribed solution such as wastewater to an acceptable level for discharge to treatment facilities. Advantages of this electrolytic oxidation of the waste fluid as compared with chemical treatment or heat treatment are enhanced efficiency of treatment such as decomposition of COD, easy operation, a simple design, a relatively small device space that is required, and relatively safe operation.

It is concerned, however, that the following problems may arise in many known methods for oxidizing the solute in the wastewater by electrolysis.
1. Most of the particular materials forming an anode for use in electrolysis are gradually corroded during use in a severe chemical environment in the electrolytic oxidation, and toxic materials are discharged to the environment.
2. Since non-recoverable metal resources such as platinum used in the electrode are consumed, a metal recovery system such as ion exchange is required to remove the platinum from the solution, which leads to further complication of the system and further increase in overall cost. Therefore, it is expected that usefulness of the electrolytic oxidation treatment method is considerably limited.
3. The platinum used in the electrode, for example, tends to be contaminated during the electrolytic oxidation of various solutes because an absorbed residue layer is formed on an operating surface of the anode.
4. Most electrolytic oxidation methods have poor energy efficiency.

As a result, the efficiency of the anode is reduced and the effective lifetime thereof is shortened. Consequently, the treatment time is prolonged, the waiting time is increased, and the overall cost of the electrolysis method is increased.

In recent years, as an effective method for treating waste fluid in which a used anode itself does not cause contamination of a solution or release of toxic substances, and further, achieves enhancement of the energy efficiency, attempts have been made to provide conductivity to a diamond by adding impurities such as boron and use the diamond in an electrode for electrochemical treatment of various types of solutions. The electrode used for such a purpose requires a material having a large area. Therefore, in the conventional art, the diamond is manufactured by the chemical vapor deposition (CVD) method in which carbon-containing gas such as methane is used as a main ingredient. The CVD method is an industrial method by which a thin film of, for example, silicon is made on a substrate in a process of manufacturing an IC and the like. According to the principle of the CVD, by providing energy to gas including an ingredient substance by heat and light or bringing the gas into the plasma state at high frequencies, the ingredient substance is radicalized and made highly reactive, and as a result, the ingredient substance is absorbed and deposited on the substrate. In the CVD method, the diamond is usually deposited on a substrate material in the form of a film during synthesis of the diamond. In addition to silicon, metals such as niobium, titanium and zirconium are used as the substrate material, for example, and the obtained diamond film is generally a polycrystal. Japanese Patent Laying-Open No. 7-299467 (Patent Document 1), for example, describes a method for treating a substance in an aqueous solution by using such a conductive diamond in an electrode for use in electrolysis of the substance in the solution.
Patent Document 1: Japanese Patent Laying-Open No. 7-299467

### DISCLOSURE OF THE INVENTION

### PROBLEMS TO BE SOLVED BY THE INVENTION

As described above, it has been seen that, when the diamond film is used in the electrode for use in electrolysis of the substance in the waste fluid such as waste water, the diamond film has excellent properties. For example, the diamond film allows treatment of the solution with high energy efficiency in a compact electrolytic treatment device. At present, however, the diamond film is not widely applied industrially. The reason for this is that, because of thermal stress generated due to a difference in thermal expansion coefficient between the substrate and the diamond film when the diamond film is formed, and/or damage to the substrate caused by ions generated by the electrolysis, the diamond film is peeled off in a short time during use, which results in a shortened life. Therefore, in order to make the diamond electrode formed by the CVD useful for use in the industry, a material for the electrode that can endure prolonged use for at least 1500 hours is required.

Therefore, an object of the present invention is to provide a diamond electrode that, in waste water treatment or production of functional water by using electrolysis, does not cause contamination of a solution or release of toxic substances, achieves enhancement of the energy efficiency, has excellent durability, and can endure prolonged use without damage. The object of the present invention is further to provide a treatment device where the above electrode is used, and a method for manufacturing the above electrode.

### MEANS FOR SOLVING THE PROBLEMS

In the present invention, a diamond electrode that can achieve a long life even if the diamond electrode is used under harsh conditions, a treatment device where the above electrode is used, and a method for manufacturing the above electrode are found as an electrode of an electrolytic treatment device used for waste water treatment or production of functional water.

In other words, an electrode of an electrolytic treatment device in the present invention includes a silicon substrate, and a conductive diamond film formed on one main surface of the silicon substrate or on both of one main surface and the other main surface located opposite thereto. The electrode is arranged to be dipped into an aqueous sodium sulfate solution, a photographic treatment solution treated advantageously by electrolysis, and the like. The electrolytic treatment device further includes a power supply unit for applying a voltage to the electrode. Thus, the treatment device that allows electrolytic treatment of the waste fluid such as the photographic treatment solution is formed.

In a case where the conductive diamond film is formed only on the one main surface of the silicon substrate, assuming that the thickness of the silicon substrate is T (µm) and the thickness of the conductive diamond film is t₁ (µm), 0.0010 ≤ t₁/T ≤ 0.022 and 10 ≤ t₁ ≤ 70. More preferably, the above ratio is 0.0020 ≤ t₁/T ≤ 0.018 and 10 ≤ t₁ ≤ 70.

In a case where the conductive diamond films are formed on both of the one main surface of the silicon substrate and the other main surface located opposite to the one main surface, assuming that the thickness of the silicon substrate is T (µm) and the thickness of the conductive diamond film formed on the above other main surface is t₂ (µm), 0.0010 ≤ t₂/T ≤ 0.022 and 10 ≤ t₂ ≤ 70. More preferably, the above ratio is 0.0020 ≤ t₂/T ≤ 0.018 and 10 ≤ t₂ ≤ 70.

The inventors have found that peeling of the electrode in a short time during use is caused mainly by stress due to a difference in thermal expansion between the diamond film and the substrate generated at the time of formation of the film. Since the thermal expansion coefficient is a value specific to a substance, it is difficult to completely eliminate the stress due to the thermal expansion coefficient. It is possible, however, to reduce the stress. The inventors have found that it is possible to reduce internal stress, to achieve a long life of the diamond film, and to improve the quality of the electrode, by forming the film such that the ratio between the thickness of the diamond film and the thickness of the substrate as well as an absolute value of the thickness of the diamond film satisfy the above numerical formulas. Furthermore, arrival of ions can be prevented by increasing the film thickness. If the film thickness is increased excessively, however, the manufacturing time is prolonged, which is not preferable from an economical viewpoint. Even for the film thickness of 10-70 µm, a sufficient long life can be achieved.

### EFFECTS OF THE INVENTION

The electrode in the present invention having the silicon substrate covered with the diamond film has high durability, and can achieve a considerably long life even if the electrode is used under harsh conditions, as compared with an electrode which has a conventional diamond film.

### BRIEF DESCRIPTION OF THE DRAWINGS

Fig. 1 is a schematic diagram schematically showing a configuration of a diamond electrode in a first embodiment of the present invention.
Fig. 2 is a flowchart of a method for manufacturing the electrode in the first embodiment of the present invention.
Fig. 3 is a schematic diagram schematically showing a configuration of a diamond electrode in a second embodiment of the present invention.
Fig. 4 is a flowchart of a method for manufacturing the electrode in the second embodiment of the present invention.
Fig. 5 is a schematic diagram schematically showing a state in which 0.1 mol/litters of an aqueous sodium sulfate solution is supplied to an electrolytic treatment device where the diamond electrodes are used for both of an anode and a cathode.

### DESCRIPTION OF THE REFERENCE SIGNS

1a, 1b electrode, 2 substrate, 3 diamond film, 4 0.1 mol/l of aqueous sodium sulfate solution, 5 electrolytic treatment device

### BEST MODES FOR CARRYING OUT THE INVENTION

Embodiments of the present invention will be described hereinafter with reference to the drawings. The same or corresponding portions are represented by the same reference characters, and description thereof will not be repeated.

### (First Embodiment)

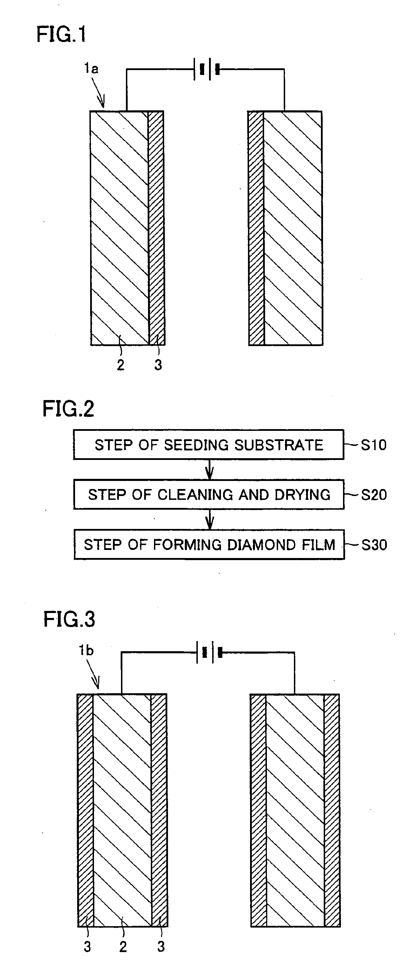

Fig. 1 is a schematic diagram schematically showing a configuration of a diamond electrode in a first embodiment of the present invention. As shown in Fig. 1, an electrode 1a in the present embodiment includes a substrate 2 and a conductive diamond film 3 covering one surface of substrate 2. It is noted that a monocrystalline silicon wafer, for example, can be used as substrate 2. Polycrystalline silicon may be used as substrate 2.

Fig. 2 is a flowchart of a method for manufacturing the electrode in the first embodiment of the present invention. Next, the method for manufacturing electrode 1a in the present embodiment will be described with reference to Fig. 2.

As shown in Fig. 2, a step of seeding a substrate (S10) is performed. Specifically, a surface of the substrate is seeded with diamond powder of #5000. Thereafter, a step of cleaning and drying the substrate (S20) is performed. After drying, a step of forming a conductive diamond film (S30) is performed. As long as the diamond film can be formed, a method for forming the film is not particularly limited.

In step (S10), the step of seeding the substrate is for colliding fine abrasive grains with the surface of the silicon substrate and making many scratches prior to cleaning, so as to promote film formation by the CVD treatment by using the scratches as nuclei.

Next, in step (S20), cleaning is performed by ultrasonic cleaning for 1 to 5 minutes with an organic solvent such as alcohol and acetone. It is noted that the frequency at the time of the ultrasonic cleaning varies depending on the size of a cleaning vessel.

Next, step of forming a conductive diamond film (S30) is performed. Specifically, the conductive diamond film is formed by the hot filament CVD method on one surface or a plurality of surfaces of cleaned substrate 2. Conditions such as the synthesis pressure of 60 Torr, the hydrogen flow rate of 3000 sccm and the methane flow rate of 90 sccm can be used as synthesis conditions. Furthermore, diborane gas is used as a boron source and a flow rate of the diborane gas is set such that the concentration thereof is 0.3% with respect to the methane. The temperature of the substrate is set to 900C°. It is noted that the thickness of the diamond film is controlled by changing the synthesis time. The method for forming the diamond film in above step (S30) is not necessarily limited to the above method, but other generally-known methods can be employed.

It is noted that a method such as the hot filament method, the microwave plasma CVD method and the ECR jet method can be used as the CVD method for synthesizing the diamond film in above step (S30). In particular, in order to form a good-quality diamond film for the electrode, it is preferable to use the hot filament method and the microwave plasma CVD method. The reason why the hot filament CVD method is preferable is that it is suitable for synthesis in a large area. Although not suitable for film formation in a large area, it is desirable to use the microwave plasma CVD method in order to synthesize a high-quality diamond film having a low impurity concentration, for example. Thus, also in the present invention, it is preferable to use the hot filament CVD method as a method for film formation.

The gas used in the CVD method includes hydrogen gas and carbon-containing gas such as methane and acetone as described above. As a doping element for providing conductivity to the diamond film, boron is the most effective, but phosphorus may be used in some cases. As an ingredient of boron, a boron-containing substance such as aforementioned diborane gas and boric acid is used. Thus, also in the present embodiment, the diborane gas is used to supply boron, so as to provide conductivity to the diamond film.

In order to study the conditions for formation of the diamond film, the inventors conducted an experiment on formation of the diamond film by using methane gas as ingredient gas, when the concentration of the methane gas with respect to the hydrogen gas is varied. A result thereof is shown in Table 1.

**[Table 1]**

| Methane Concentration | Thickness of Diamond Film | Synthesis Rate | Oxygen Generation Potential |
|---|---|---|---|
| 0.2% | 2.4µm | 0.06µm/hr | 2.3V |
| 1% | 14.8µm | 0.37µm/hr | 2.2V |
| 2% | 31.2µm | 0.78µm/hr | 2.0V |
| 3% | 50.5µm | 1.26µm/hr | 1.8V |
| 4% | 61.2µm | 1.53µm/hr | 1.5V |

Table 1 shows "thickness" and "oxygen generation potential" of the synthesized diamond film when the diamond film is formed by the hot filament CVD method by using methane and a diamond is synthesized onto the silicon substrate for 40 hours in respective methane concentrations.

According to the result in Table 1, when the methane concentration is less than or equal to 0.2%, a synthesis rate of the diamond film is extremely low. It takes too long to form the film having a film thickness of greater than or equal to 10 µm, which is not practical. Furthermore, it is seen that, when the methane concentration exceeds 3%, the quality of the diamond is degraded, and therefore, the oxygen generation potential is low, that is, the performance as the electrode for use in electrolysis is not sufficient.

Therefore, for example, in a case where methane is used as the carbon-containing gas, it is preferable that the proportion of the carbon-containing gas (methane gas) to the hydrogen gas ranges between 1% and 3%.

### (Second Embodiment)

Fig. 3 is a schematic view schematically showing a configuration of a diamond electrode in a second embodiment of the present invention. As shown in Fig. 3, an electrode 1b in the present embodiment differs from that in the first embodiment only in that electrode 1b includes conductive diamond films 3 covering two surfaces, that is, the main surface of substrate 2 and the back surface thereof.

In a case where an electrolysis device of a hybrid structure having more than one set of the electrodes is formed, the electrode includes diamond films 3 on both surfaces, that is, the main surface of substrate 2 and the back surface thereof. The conditions such as the film thickness and the film quality of the components forming electrode 1b are the same as those in the first embodiment. Furthermore, the film thickness and the film quality of diamond film 3 formed on the back surface of substrate 2 are similar to those of diamond film 3 formed on the front surface of substrate 2.

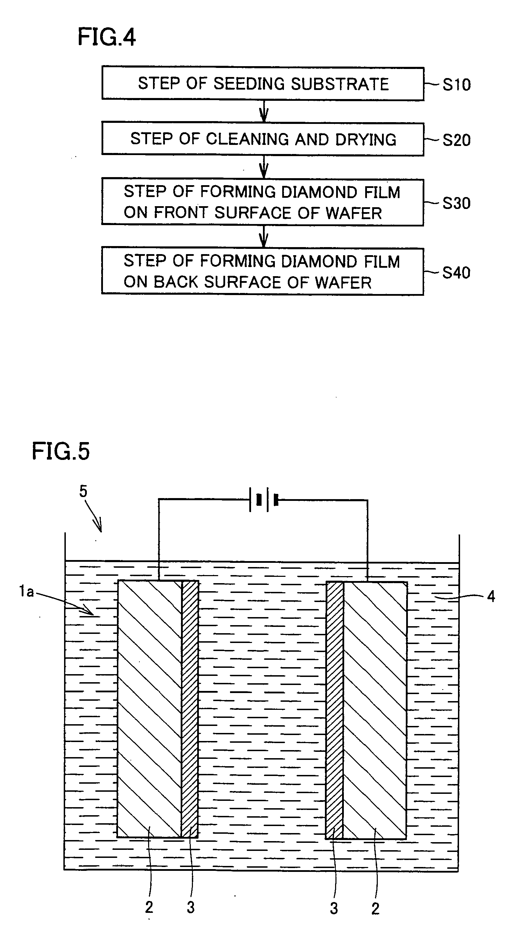

Fig. 4 is a flowchart of a method for manufacturing the electrode in the second embodiment of the present invention. Step of seeding the substrate (S10) to step of forming the diamond film on the main surface of the substrate (S30) are the same as those in the method for manufacturing the electrode in the first embodiment shown in Fig. 2. The method in the second embodiment differs from that in the first embodiment only in that a step of forming the diamond film on the back surface of the substrate in a similar manner (S40) is added after step (S30).

### Example 1

Although the present invention will be hereinafter described more specifically according to examples, the present invention is not limited to these examples.

In the present example, a monocrystalline silicon wafer having an orientation of (100) and a diameter of 6 inches is prepared for use as the substrate, when the thickness of the wafer is varied differently as shown in Table 2. As in the specific example of the manufacturing method described above, each surface of monocrystalline silicon is seeded with the diamond powder of #5000, and then, the wafer is cleaned and dried. On one main surface of the substrate prepared in such a manner, a conductive diamond film is formed by the hot filament CVD method. The thickness of the diamond film is controlled by changing the synthesis time.

### (Comparative Example)

As comparative examples, a diamond film having a thickness of less than 10 µm (comparative example 1), a diamond film having a thickness exceeding 70 µm (comparative example 2) and diamond films having a ratio between the thickness of the diamond film and the thickness of the substrate is outside the scope of claims (comparative examples 3 to 6) are fabricated under the same conditions as those in the above, and comparative evaluation is conducted.

### (Method for Measuring)

An electrolytic treatment experiment is conducted by using the diamond electrodes fabricated by the above-described method, and an experiment is conducted to check durability of the respective electrodes. As shown in Fig. 5, 0.1 mol/litters of a circulating aqueous sodium sulfate solution 4 is supplied to an electrolytic treatment device 5 where the diamond electrodes are used for both of an anode and a cathode, and the electrolytic treatment is performed. A spacing between the electrodes is maintained at 10 mm and the current density is maintained at 0.3 A/cm². The durability is checked by stopping the electrolytic experiment every 100 hours to observe the condition of the diamond film, and extending the test time for another 100 hours if an abnormality is not found. Based on such a test, a time period during which the experiment can be continued until the diamond film is peeled off is recorded. A result thereof is shown in Table 2.

**[Table 2]**

| No. | Thickness of Substrate (mm) | Thickness of Diamond Film (µm) | Thickness of Film (µm)/ Thickness of Substrate (mm)/1000 | Durability |
|---|---|---|---|---|
| 1 | 3 | 10 | 0.0033 | peeling of film after 4800 hours |
| 2 | 15 | 15 | 0.001 | peeling of film after 1600 hours |
| 3 | 1 | 20 | 0.020 | peeling of film after 3400 hours |
| 4 | 12 | 20 | 0.0017 | peeling of film after 3100 hours |
| 5 | 3 0 | 35 | 0.0012 | peeling of film after 1700 hours |
| 6 | 23 | 40 | 0.0017 | peeling of film after 3500 hours |
| 7 | 3 | 52 | 0.017 | peeling of film after 5700 hours |
| 8 | 30 | 60 | 0.002 | peeling of film after 4900 hours |
| 9 | 3 | 65 | 0.022 | peeling of film after 1800 hours |
| Comparative Example 1 | 3 | 8 | 0.0027 | peeling of film after 500 hours |
| Comparative Example 2 | 6 | 75 | 0.0125 | peeling of film after 600 hours |
| Comparative Example 3 | 15 | 12 | 0.00080 | peeling of film after 500 hours |
| Comparative Example 4 | 1 | 25 | 0.025 | peeling of film after 600 hours |
| Comparative Example 5 | 50 | 40 | 0.00080 | peeling of film after 700 hours |
| Comparative Example 6 | 2 | 52 | 0.026 | peeling of film after 700 hours |

### (Result of Measuring)

As shown in Table 2, the diamond film of the electrode fabricated under the conditions satisfying the numerical formulas described in the above scope of claims as to the thicknesses of the substrate and the diamond film that are used as the electrode endures for about 1500 to 5000 hours and has a long life. On the other hand, it is seen that the diamond film of the electrode fabricated under the conditions that are outside the above scope of claims, which is indicated by comparative examples 1 to 6, is peeled off only after 500 to 700 hours and has a shortened life.

As described above, according to the present example, it can be found out that, assuming that the thickness of the silicon substrate is T (µm) and the thickness of the conductive diamond film formed on one main surface of the silicon substrate is t (µm), the electrode formed such that the ratio between the thickness of the silicon substrate and the thickness of the conductive diamond film is 0.0010 ≤ t/T ≤ 0.022 and 10 ≤ t ≤ 70 can be operated for a long time without peeling of the diamond film and practical application can be expected. Furthermore, as a result of detailed observation of the result of the example, it is found that the diamond electrode can endure further prolonged use without peeling when the ratio indicated by the above numerical formulas is preferably 0.0015 ≤ t/T ≤ 0.020, and more preferably 0.0020 ≤ t/T ≤ 0.018.

Conversely, it can be said that the diamond film of the electrode formed under the conditions that are outside the conditions of the above numerical formulas is peeled off in a short time and the stable quality cannot be ensured.

It should be understood that the embodiments disclosed herein are illustrative and not limitative in any respect. The scope of the present invention is defined by the terms of the claims, rather than the description above, and is intended to include any modifications within the scope and meaning equivalent to the terms of the claims.

### INDUSTRIAL APPLICABILITY

The diamond electrode in the present invention is particularly suitable for the art related to an electrode used for waste water treatment or production of functional water by using electrolysis.

## Claims

1. A diamond electrode (1a, 1b), comprising:
a silicon substrate (2); and
a conductive diamond film (3) formed on one main surface of said silicon substrate (2),
assuming that a thickness of said silicon substrate (2) is T (µm) and a thickness of said conductive diamond film (3) is t₁ (µm), relational expressions of 0.0010 ≤ t₁/T ≤ 0.022 and 10 ≤ t₁ ≤ 70 being satisfied.

2. The diamond electrode (1b) according to claim 1, further comprising another conductive diamond film (3) formed on the other main surface located opposite to said one main surface of said silicon substrate (2),
assuming that a thickness of said another conductive diamond film (3) is t₂ (µm), relational expressions of 0.0010 ≤ t₂/T ≤ 0.022 and 10 ≤ t₂ ≤ 70 being satisfied.

3. A treatment device (5), comprising:
the diamond electrode (1a, 1b) according to claim 1;
a treatment vessel within which said diamond electrode (3) is arranged; and
a power supply unit for applying a voltage to said diamond electrode (3).

4. A method for manufacturing the diamond electrode (1a, 1b) according to claim 1, comprising the steps of:
preparing a silicon substrate (2); and
forming a conductive diamond film (3) on one main surface of said silicon substrate (2),
in said step of forming a conductive diamond film (3), the conductive diamond film (3) is formed such that, assuming that a thickness of said silicon substrate (2) is T (µm) and a thickness of the conductive diamond film (1a, 1b) is t₁ (µm), relational expressions of 0.0010 ≤ t₁/T ≤ 0.022 and 10 ≤ t₁ ≤ 70 are satisfied.

5. The method for manufacturing the diamond electrode (1b) according to claim 2, further comprising the step of
forming another conductive diamond film (3) on the other main surface located opposite to said one main surface of said silicon substrate (2),
in said step of forming another conductive diamond film (3), said another conductive diamond film (3) is formed such that, assuming that the thickness of said silicon substrate (2) is T (µm) and a thickness of said another conductive diamond film (3) is t₂ (µm), relational expressions of 0.0010 ≤ t₂/T ≤ 0.022 and 10 ≤ t₂ ≤ 70 are satisfied.
